# EUROPEAN PATENT APPLICATION

(11) **EP 3 890 027 A1**
(43) Date of publication of application: **06.10.2021**
(21) Application number: 19889318.2
(22) Date of filing: 25.11.2019
(51) Int. Cl.: H01L 27/32

(54) **ARRAY SUBSTRATE AND DISPLAY DEVICE**

(30) Priority: 26.11.2018 CN 201821952246 U
(71) Applicant: BOE TECHNOLOGY GROUP CO., LTD., Beijing 100015 (CN); Beijing BOE Technology Development Co., Ltd., Beijing 100176 (CN)
(72) Inventor: MA, Yongda, Beijing 100176 (CN); HAO, Xueguang, Beijing 100176 (CN); WU, Xinyin, Beijing 100176 (CN); QIAO, Yong, Beijing 100176 (CN)
(74) Representative: Isarpatent
(86) International application number: PCT/CN2019/120580
(87) International publication number: WO 2020/108429

(57) **Abstract**

An array substrate and a display device are provided. The array substrate includes: a substrate body; and a plurality of first signal lines arranged on the substrate body, each first signal line including a first line segment, a second line segment, and a third line segment connecting the first line segment and the second line segment. The plurality of first signal lines is arranged at intervals in a first direction. In a second direction perpendicular to the first direction, a first/second/third region is formed between any two adjacent first/second/third line segments. At least parts of subpixel units are arranged at the first regions and the third regions, and each second line segment is connected to a terminal connection line at a periphery of a non-display region of the substrate body adjoining a display region. At least two adjacent second regions have a same width in the first direction.

## Description

### CROSS-REFERENCE TO RELATED APPLICATION

The present application claims a priority of the Chinese patent application No.201821952246.9 filed on November 26, 2018, which is incorporated herein by reference in its entirety.

### TECHNICAL FIELD

The present disclosure relates to the field of display technology, in particular to an array substrate and a display device.

### BACKGROUND

In a display panel in a related art, an area of a light-emitting surface of each pixel is limited due to a light-shielding layer, so an aperture ratio is reduced. In order to ensure the aperture ratio while taking an area of a light-emitting surface of each subpixel into consideration, it is necessary to provide longitudinal signal lines at different intervals in the related art. At this time, a density of lead lines connecting the longitudinal signal lines and a terminal is too large. Hence, it is difficult to perform an etching process during the manufacture of an array substrate, and the yield thereof is adversely affected.

### SUMMARY

An object of the present disclosure is to provide an array substrate and a display device, so as to solve the above-mentioned problem.

In one aspect, the present disclosure provides in some embodiments an array substrate, including: a substrate body including a display region and a non-display region; and a plurality of first signal lines arranged at the display region of the substrate body, each first signal line including a first line segment, a second line segment, and a third line segment arranged between, and connecting, the first line segment and the second line segment. The plurality of first signal lines is arranged at intervals in a first direction. In a second direction perpendicular to the first direction, a first region is formed between any two adjacent first line segments, a second region is formed between any two adjacent second line segments, and a third region is formed between any two adjacent third line segments. At least parts of subpixel units are arranged at the first regions and the third regions, and each second line segment is connected to a terminal connection line at a periphery of the non-display region of the substrate body adjoining the display region. At least two adjacent second regions have a same width in the first direction, and with respect to the first region and the second region formed by two adjacent first signal lines in each of at least one group of two adjacent first signal lines, a width of the first region is different from the width of the second region in the first direction.

In a possible embodiment of the present disclosure, all the second regions on the substrate body have a same width in the first direction.

In a possible embodiment of the present disclosure, in each group of two adjacent first signal lines where the width of the first region is different from the width of the second region in the first direction, the first line segment and the second line segment of a preset first signal line extend in the second direction and belong to different straight lines.

In a possible embodiment of the present disclosure, the preset first signal line is one of the two adjacent first signal lines, and the other first signal line is a straight line extending in the second direction.

In a possible embodiment of the present disclosure, each of the two adjacent first signal lines is the preset first signal line.

In a possible embodiment of the present disclosure, a width of the first line segment of the preset first signal line is greater than a width of the second line segment of the preset first signal line.

In a possible embodiment of the present disclosure, a first subpixel unit and a second subpixel unit are arranged at two sides of each preset first signal line respectively, an area of the first subpixel unit is smaller than an area of the second subpixel unit, and each of the first line segment and the third line segment of the preset first signal line protrudes toward the first subpixel unit relative to the second line segment of the preset first signal line.

In a possible embodiment of the present disclosure, a width of a portion of the first line segment of each preset first signal line protruding toward the first subpixel unit relative to the second line segment of the preset first signal line is positively correlated to a ratio of the area of the second subpixel unit to the area of the first subpixel unit.

In a possible embodiment of the present disclosure, the array substrate further includes a third subpixel unit arranged at a side of the second subpixel unit away from the first subpixel unit, and a ratio of the area of the first subpixel unit to the area of the second subpixel unit is positively correlated to a value of (W1-(C1-a1))/(W1+(C1-b1)+(C2-b2)), where W1 represents the width of the second region in the first direction, C1 represents a vertical distance between an extension line of an edge of a second line segment of a preset first signal line, which is located between the first subpixel unit and the second subpixel unit and located away from the first subpixel unit, and an edge of a first line segment of the preset first signal line away from the second subpixel unit, C2 represents a vertical distance between an extension line of an edge of a second line segment of a preset first signal line, which is located between the second subpixel unit and the third subpixel unit and located away from the third subpixel unit, and an edge of a first line segment of the preset first signal line away from the second subpixel unit, a1 represents a width of the second line segment of the preset first signal line between the first subpixel unit and the second subpixel unit, b1 represents a width of the first line segment of the preset first signal line between the second subpixel unit and the third subpixel unit, and b2 represents a width of the first line segment of the preset first signal line between the second subpixel unit and the third subpixel unit.

In a possible embodiment of the present disclosure, the second line segment and the third line segment each serve as a light-shielding layer between two adjacent subpixel units.

In a possible embodiment of the present disclosure, the array substrate further includes a plurality of connection terminals connected to the terminal connection lines of the plurality of first signal lines respectively. The plurality of connection terminals is arranged at intervals in the first direction, a total queue length of the plurality of connection terminals is smaller than a total queue length of the plurality of first signal lines in the first direction.

In a possible embodiment of the present disclosure, the array substrate further includes a plurality of second signal lines arranged on the substrate body and each crossing the plurality of first signal lines. The second line segment of each preset first signal line extends across each second signal line, and the width of the second line segment of each preset first signal line is smaller than the width of the first line segment of the preset first signal line.

In a possible embodiment of the present disclosure, each second signal line extends in the second direction.

In a possible embodiment of the present disclosure, each first signal line is a data line or a VDD power source line, and each second signal line is a gate line.

In another aspect, the present disclosure provides in some embodiments a display device including the above-mentioned array substrate.

### BRIEF DESCRIPTION OF THE DRAWINGS

Fig.1 is a schematic view showing an array substrate in the related art;
Fig.2 is a partially schematic view of an array substrate according to one embodiment of the present disclosure;
Fig.3 is another partially schematic view of the array substrate according to one embodiment of the present disclosure; and
Fig.4 is a schematic view showing the array substrate according to one embodiment of the present disclosure.

### DETAILED DESCRIPTION

In order to make the objects, the technical solutions and the advantages of the present disclosure more apparent, the present disclosure will be described hereinafter in a clear and complete manner in conjunction with the drawings and embodiments.

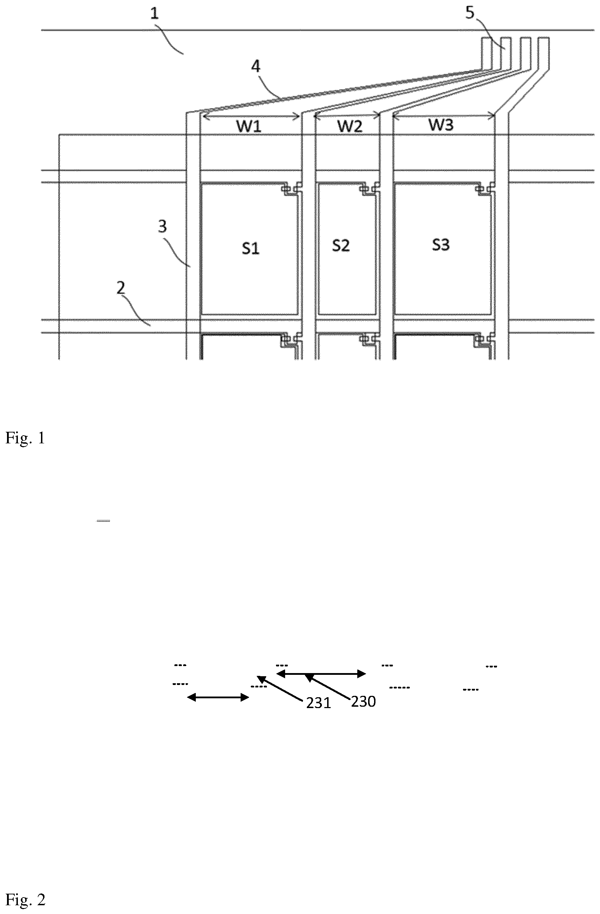

In the related art, as shown in Fig.1, signal lines are arranged on a substrate body 1 of an array substrate, a plurality of first signal lines 2 is arranged in a horizontal direction, and a plurality of second signal lines 3 is arranged in a vertical direction. The first signal lines 2 are arranged to cross the second signal lines 3 so as to define a plurality of rectangular regions, i.e., light-transmitting regions of subpixels. Usually, the first signal line 2 is a gate line, and the second signal line 3 is a data line or a VDD power source line.

In Fig.1, when the second signal lines 3 are spaced apart from each other at different intervals, areas S1, S2 and S3 of the light-transmitting regions of the subpixels are different from each other. In addition, due to the different intervals, points where the second signal lines 3 are connected to lead lines 4 are spaced apart from each other at different intervals, so a density of the lead lines 4 connecting the second signal lines 3 and a terminal 5 is too large.

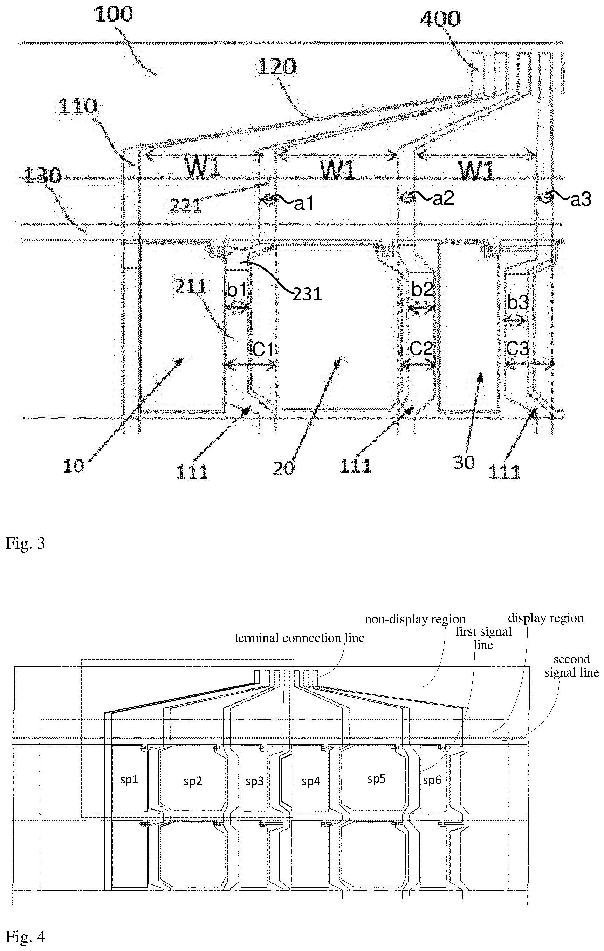

As shown in Fig.4, the present disclosure provides in some embodiments an array substrate. A substrate body of the array substrate is provided with a display region and a non-display region, and subpixel units sp1 to sp6, first signal lines, second signal lines and terminal connection lines are arranged on the display region and the non-display region. In Fig.4, the subpixel units sp1, sp2 and sp3 may be combined into one RGB pixel unit and the subpixel units sp4, sp5 and sp6 may be combined into another RGB pixel unit; or the subpixel units sp1, sp2, sp3 and sp4 may be combined into one RGBW pixel unit; or the subpixel unit sp1 may be a dummy subpixel, and in this case, the subpixel units sp2, sp3 and sp4 may be combined into one RGB pixel unit, or the subpixel units sp2, sp3, sp4 and sp5 may be combined into one RGBW pixel unit. The subpixel units sp1 to sp4 may have different sizes.

Figs.2 and 3 show a portion of the array substrate indicated by a dotted box in Fig.4. As shown in Fig.2, the array substrate may include: a substrate body 100; and a plurality of first signal lines 110 arranged on the substrate body 100 at intervals in a first direction a. Each first signal line 110 may include a first line segment 211, a second line segment 221, and a third line segment 231 arranged between, and connecting, the first line segment 211 and the second line segment 221. To be specific, as shown in Fig.2, a portion of the first signal line 110 located between two short dotted lines may be just the third line segment 231, and the third line segment 231 may be located between, and connect, the first line segment 211 and the second line segment 221. In a second direction b perpendicular to the first direction a, a first region 210 may be formed between any two adjacent first line segments 211, a second region 220 may be formed between any two adjacent second line segments 221, and a third region 230 may be formed between any two adjacent third line segments 231. At least parts of subpixel units 300 may be arranged within the first regions 210 and the third regions 230, and each second line segment 221 may be connected to a terminal connection line 120 at a periphery of the non-display region of the substrate body 100 adjoining the display region.

The second regions 220 each between two adjacent second line segments 221 may have a same width. In at least one group of two adjacent first signal lines 110, a width of the first region 210 may be different from the width of the second region 220 in the first direction a. The third region 230 may be a transition region between the first region 210 and the second region 220, a length of a side of the third region 230 adjoining the first region 210 may be equal to the width of the first region 210 along the first direction a, and a length of a side of the third region 230 adjoining the second region 220 may be equal to the width of the second region 220 along the first direction a.

According to the array substrate in the embodiments of the present disclosure, the first region 210 and the third region 230 may be provided between two adjacent first signal lines 110 based on areas of the subpixel units. Each second line segment 221 may be connected to the terminal connection line 120 at the periphery of the non-display region of the substrate body 100 adjoining the display region, and the width of the two adjacent second regions 220 may be a constant value. Hence, the first signal lines 110 may be spaced apart from each other at an identical interval at points where the first signal lines 110 are connected to the terminal connection lines 120, i.e., the interval may not change with the area of the subpixel unit. As a result, it is able to solve the problem in the related art where it is difficult to perform an etching process and the yield thereof is adversely affected due to the too large density of the lead lines connected to the signal lines when the second line segments are spaced apart from each other at different intervals.

In the embodiments of the present disclosure, as shown in Fig.2, the array substrate may further include a plurality of second signal lines 130 arranged on the substrate body 100, the plurality of second signal lines cross the plurality of first signal lines 110 to define a plurality of pixel setting regions, i.e., the display region of the array substrate. One subpixel unit 300 may be arranged at each pixel setting region.

In a possible embodiment of the present disclosure, the second signal line 130 may be arranged perpendicular to the first signal line 110. Of course, the second signal line 130 may also be angled relative to the first signal line 110 at an angle other than 90°, as long as the second signal lines 130 may cross the first signal lines 110 to define the plurality of pixel setting regions.

In a possible embodiment of the present disclosure, the first signal line 110 may be a data line or a VDD power source line, and the second signal line 130 may be a gate line. In addition, the plurality of first signal lines 110 may be arranged in a vertical direction and spaced apart from each other in a horizontal direction, and the plurality of second signal lines 130 may be arranged in the horizontal direction and spaced apart from each other in the vertical direction, i.e., the first direction a may be the horizontal direction and the second direction b may be the vertical direction.

As shown in Fig.2, when the width of the first region 210 is different from the width of the second region 220 in the first direction a, a preset first signal line 111 of the two adjacent first signal lines 110 may include at least two line segments extending in the second direction and belonging to different straight lines. The two line segments may be the first line segment 211 for forming the first region 210 and the second line segment 221 for forming the second region 220.

Based on the above arrangement mode, when two adjacent subpixel units have different areas, each preset first signal line 11 for forming the corresponding subpixel unit may include the first line segment 211 and the second line segment 221 belonging to different straight lines, and the third line segment 231 connecting the first line segment 211 and the second line segment 221, i.e., the preset first signal line 111 may be a folded line. The first line segment 211 of each preset first signal line 111 for forming the first region 210 and the adjacent first signal line 110 may be arranged to define a region where the subpixel unit is located. The second line segment 221 of each preset first signal line 111 for forming the second region 220 may be connected to the terminal connection line 120 and spaced apart from the adjacent first signal line 110 by a predetermined interval, so that the two adjacent first signal lines 110 may be spaced apart from each other at an identical interval at the points where the first signal lines 110 are connected to the terminal connection lines 120, without any change with the areas of the subpixel units.

As shown in Figs.2 and 3, in a possible embodiment of the present disclosure, among a first subpixel unit 10, a second subpixel unit 20 and a third subpixel unit 30, one of two first signal lines 110 for forming the first subpixel unit 10 may be a straight line extending in the second direction b, and the other first signal line 110 may be a folded line, i.e., the preset first signal line 111; and the two first signal lines 110 for forming the second subpixel unit 20 and the third subpixel unit 30 may be folded lines, i.e., the preset first signal lines 111. As shown in Figs.2 and 3, the third line segment 231 of each preset first signal line 111 may be connected to a thin film transistor (TFT) of a corresponding subpixel unit 10, 20 or 30.

In a possible embodiment of the present disclosure, each first signal line 110 as a straight line may have an identical width in the first direction a.

In the embodiments of the present disclosure, as shown in Fig.2, in the first direction a, the width of the first line segment 211 of each preset first signal line 111 for forming the first region 210 may be greater than the width of the second line segment 221 of the preset first signal line 111 for forming the second region 220.

For example, as shown in Fig.3, for the preset first signal line 111 for forming the first subpixel unit 10, in the first direction a, the width of the first line segment 211 for forming the first region may be b1, the width of the second line segment 221 for forming the second region 220 may be a1, and b1 may be greater than a1. Similiarly, for a preset first signal line 111 for forming the other subpixel unit, the width of the first line segment 211 for forming the first region 210 may also be greater than the width of the second line segment 221 for forming the second region 220, e.g., in Fig.2, b2 may be greater than a2, and b3 may be greater than a3. In this regard, it is able to reduce a resistance of the first signal line.

In a possible embodiment of the present disclosure, the second line segments 221 of the preset first signal lines 111 for forming the second regions 220 may have a same width.

Because the plurality of first signal lines 111 cross the plurality of second signal lines 130, each preset first signal line 111 may further include a plurality of portions each extending across a corresponding second signal line 130. In the embodiments of the present disclosure, a width of the portion of each preset first signal line 111 extending across the corresponding second signal line 130 may be smaller than the width of the first line segment 211 for forming the first region 210. In addition, as shown in Fig.2, the second line segment 221 of each preset first signal line 111 for forming the second region 220 may also extend across the corresponding second signal line 130. The portions of each preset first signal line 111 extending across the second signal lines 130 may belong to a same straight line and have a same width.

In addition, in the embodiments of the present disclosure, as shown in Fig.3, subpixel units, e.g., the first subpixel unit 10 and the second subpixel unit 20, may be arranged at two sides of each preset first signal line 111 respectively, and the first subpixel unit 10 may have an area smaller than that of the second subpixel unit 20, so the first line segment 211 and the third line segment 231 of the preset first signal line 111 for forming the first region 210 and the third region 230 may protrude toward the first subpixel unit 10 relative to the second line segment 221 for forming the second region 220.

Similiarly, the third subpixel unit 30 may have an area smaller than that the second subpixel unit 20, and the preset first signal line 111 between the second subpixel unit 20 and the third subpixel unit 30 may protrude toward the second subpixel unit 20 with a smaller area.

Further, in the embodiments of the present disclosure, when a first subpixel unit and a second subpixel unit having different areas are arranged at two sides of the preset first signal line 111 respectively, a width of a portion of the first line segment 211 of the preset first signal line 111 protruding toward the first subpixel unit (i.e., the subpixel unit with a smaller area) relative to the second line segment 221 (i.e., a movement distance of the first line segment 211 relative to the second line segment 221 in a direction opposite to the first direction a) may be positively correlated to a ratio of the area of the second subpixel unit to the area of the first subpixel unit.

For example, as shown in Fig.3, the first subpixel unit 10, the second subpixel unit 20 and the third subpixel unit 30 may have areas S1, S2 and S3 respectively, where S1 is smaller than S2, a ratio of S1 to S2 is M, S2 is greater than S3, and a ratio of S2 to S3 is N.

In addition, for the preset first signal line 111 between the first subpixel unit 10 and the second subpixel unit 20 and the preset first signal line 111 between the second subpixel unit 20 and the third subpixel unit 30, the widths of the second line segments 221 for forming the second regions 220 may be a1 and a2 respectively, and the widths of the first line segments 211 for forming the first regions 210 may be b1 and b2 respectively. For the preset first signal line 111 between the first subpixel unit 10 and the second subpixel unit 20, a width of the portion of the first segment 211 protruding toward the first subpixel unit 10 relative to the second line segment 221 may be C1-a1, and for the preset first signal line 111 between the second subpixel unit 20 and the third subpixel unit 30, a width of the portion of the first segment 211 protruding toward the third subpixel unit 30 relative to the second line segment 221 may be C2-a2, where C represents a vertical distance between an extension line of an edge the preset first signal line and an extension line of an opposite edge of the preset first signal line. For example, as shown in Fig.3, C1 represents a vertical distance between an extension line of a right edge of the second line segment 221 of the preset first signal line 111 between the first subpixel unit 10 and the second subpixel unit 20 and a left edge of the first line segment 211 of the preset first signal line 111, and C2 represents a vertical distance between an extension line of a left edge of the second line segment 211 of the preset first signal line 111 between the second subpixel unit 20 and the third subpixel unit 30 and a right edge of the first line segment 211 of the preset first signal line 111.

To be specific, the ratio of the area S1 of the first subpixel unit 10 to the area S2 of the second subpixel unit 20 may be positively correlated to a value of (W1-(C1-a1))/(W1+(C1-b1)+(C2-b2)), where W1 represents the width of the second region 220 in the first direction a. As mentioned hereinabove, the width of the second region 220 between every two adjacent first signal lines 110 may be a constant value. In other words, the ratio of the area S1 of the first subpixel unit 10 to the area S2 of the second subpixel unit 20 may be positively correlated to a ratio of the width of the first subpixel unit 10 in the first direction a and the width of the second subpixel unit 20 in the first direction a.

In the embodiments of the present disclosure, as shown in Figs.2 and 3, the array substrate may further include a plurality of connection terminals 400 connected to the terminal connection lines 120 for the first signal lines 110 respectively. The plurality of connection terminals 400 may be arranged at intervals in the first direction a, and a total queue length of the plurality of connection terminals 400 in the first direction a may be smaller than a total queue length of the plurality of first signal lines 110 in the first direction a.

In a possible embodiment of the present disclosure, the first line segment 211 of each first signal line 110 for forming the first region 210 may be a light-shielding layer between two adjacent subpixel units, so as to shield light passing through between the adjacent subpixel units.

According to the array substrate in the embodiments of the present disclosure, when the subpixel units on the array substrate have different areas, the preset first signal line may protrude toward the subpixel unit with a smaller area. In addition, the first signal lines may be arranged at a same interval at points where the first signal lines are connected to the terminal connection lines, i.e., the interval may not change with the areas of the subpixel units. As a result, it is able to solve the problem in the related art where it is difficult to perform an etching process and the yield thereof is adversely affected due to the too large density of the lead lines connected to the signal lines when the signal lines are spaced apart from each other at different intervals.

The present disclosure further provides in some embodiments a display device including the above-mentioned array substrate. Based on Figs.2 and 3 and the above-mentioned description, a structure of the display device may be understandable for a person skilled in the art, and thus will not be particularly defined herein.

The above embodiments are for illustrative purposes only, but the present disclosure is not limited thereto. Obviously, a person skilled in the art may make further modifications and improvements without departing from the spirit of the present disclosure, and these modifications and improvements shall also fall within the scope of the present disclosure.

## Claims

1. An array substrate, comprising:
a substrate body comprising a display region and a non-display region; and
a plurality of first signal lines arranged at the display region of the substrate body, each first signal line comprising a first line segment, a second line segment, and a third line segment arranged between, and connecting, the first line segment and the second line segment,
wherein the plurality of first signal lines is arranged at intervals in a first direction;
in a second direction perpendicular to the first direction, a first region is formed between any two adjacent first line segments, a second region is formed between any two adjacent second line segments, and a third region is formed between any two adjacent third line segments;
at least parts of subpixel units are arranged at the first regions and the third regions, and each second line segment is connected to a terminal connection line at a periphery of the non-display region of the substrate body adjoining the display region; and
at least two adjacent second regions have a same width in the first direction, and with respect to the first region and the second region formed by two adjacent first signal lines in each of at least one group of two adjacent first signal lines, a width of the first region in the first direction is different from the width of the second region in the first direction.

2. The array substrate according to claim 1, wherein all the second regions on the substrate body have a same width in the first direction.

3. The array substrate according to claim 2, wherein in each group of two adjacent first signal lines where the width of the first region is different from the width of the second region in the first direction, the first line segment and the second line segment of a preset first signal line extend in the second direction and belong to different straight lines.

4. The array substrate according to claim 3, wherein the preset first signal line is one of the two adjacent first signal lines, and the other first signal line is a straight line extending in the second direction.

5. The array substrate according to claim 3, wherein each of the two adjacent first signal lines is the preset first signal line.

6. The array substrate according to claim 3, wherein a width of the first line segment of the preset first signal line is greater than a width of the second line segment of the preset first signal line.

7. The array substrate according to claim 3, wherein a first subpixel unit and a second subpixel unit are arranged at two sides of each preset first signal line respectively, an area of the first subpixel unit is smaller than an area of the second subpixel unit, and each of the first line segment and the third line segment of the preset first signal line protrudes toward the first subpixel unit relative to the second line segment of the preset first signal line.

8. The array substrate according to claim 7, wherein a width of a portion of the first line segment of each preset first signal line protruding toward the first subpixel unit relative to the second line segment of the preset first signal line is positively correlated to a ratio of the area of the second subpixel unit to the area of the first subpixel unit.

9. The array substrate according to claim 7, further comprising a third subpixel unit arranged at a side of the second subpixel unit away from the first subpixel unit, and a ratio of the area of the first subpixel unit to the area of the second subpixel unit is positively correlated to a value of (W1-(C1-a1))/(W1+(C1-b1)+(C2-b2)), where W1 represents the width of the second region in the first direction, C1 represents a vertical distance between an extension line of an edge of a second line segment of a preset first signal line, which is located between the first subpixel unit and the second subpixel unit and located away from the first subpixel unit, and an edge of a first line segment of the preset first signal line away from the second subpixel unit, C2 represents a vertical distance between an extension line of an edge of a second line segment of a preset first signal line, which is located between the second subpixel unit and the third subpixel unit and located away from the third subpixel unit, and an edge of a first line segment of the preset first signal line away from the second subpixel unit, a1 represents a width of the second line segment of the preset first signal line between the first subpixel unit and the second subpixel unit, b1 represents a width of the first line segment of the preset first signal line between the second subpixel unit and the third subpixel unit, and b2 represents a width of the first line segment of the preset first signal line between the second subpixel unit and the third subpixel unit.

10. The array substrate according to claim 2, wherein the second line segment and the third line segment each serve as a light-shielding layer between two adjacent subpixel units.

11. The array substrate according to claim 2, further comprising a plurality of connection terminals connected to the terminal connection lines of the plurality of first signal lines respectively, wherein the plurality of connection terminals is arranged at intervals in the first direction, a total queue length of the plurality of connection terminals in the first direction is smaller than a total queue length of the plurality of first signal lines in the first direction.

12. The array substrate according to claim 3, further comprising a plurality of second signal lines arranged on the substrate body and crossing the plurality of first signal lines, wherein the second line segment of each preset first signal line extends across each second signal line, and the width of the second line segment of each preset first signal line is smaller than the width of the first line segment of the preset first signal line.

13. The array substrate according to claim 12, wherein each second signal line extends in the second direction.

14. The array substrate according to claim 12 or 13, wherein each first signal line is a data line or a VDD power source line, and each second signal line is a gate line.

15. A display device, comprising the array substrate according to any one of claims 1 to 14.
